# FASCICULE DE BREVET EUROPEEN

(11) **EP 1 713 683 B1**
(45) Date de publication et mention de la délivrance du brevet: **21.05.2008**
(21) Numéro de dépôt: 05717607.5
(22) Date de dépôt: 10.02.2005
(51) Int. Cl.: B62J 6/00, B60Q 11/00, G07B 15/00, B62H 5/20

(54) **BICYCLETTE MUNIE D'UN SYSTEME DE CONTROLE EMBARQUE ET SYSTEME AUTOMATIQUE DE LOCATION COMPRENANT DE TELLES BICYCLETTES**
FAHRRAD MIT EINEM BORD-STEUERSYSTEM UND EIN FAHRRÄDER UMFASSENDES AUTOMATISCHES VERMIETSYSTEM
BICYCLE PROVIDED WITH AN ON-BOARD CONTROL SYSTEM AND AUTOMATIC RENTAL SYSTEM COMPRISING SAID BICYCLES

(30) Priorité: 10.02.2004 FR 0401290
(43) Date de publication de la demande: 25.10.2006
(73) Titulaire: JCDecaux SA, 92200 Neuilly-Sur-Seine (FR)
(72) Inventeur: LE GARS, Jacques, F-78950 Gambais (FR); LAMY, Jean-Claude, F-92500 Reuil Malmaison (FR); DARRAS, Jacques, F-78120 Rambouillet (FR); TAVERNIER, Patrick, F-78410 Bouafle (FR)
(74) Mandataire: Burbaud, Eric
(86) Numéro de dépôt international: PCT/FR2005/000316
(87) Numéro de publication internationale: WO 2005/077740

(56) Documents cités:
- WO-A-01/54080
- WO-A-02/39787
- WO-A-02/095698
- DE-A- 10 142 358
- DE-U- 20 114 272
- US-A- 3 904 920
- US-A- 5 955 945
- US-A- 5 986 548
- US-B1- 6 191 685
- PATENT ABSTRACTS OF JAPAN vol. 2003, no. 05, 12 mai 2003 (2003-05-12) & JP 2003 016567 A (SANYO ELECTRIC CO LTD), 17 janvier 2003 (2003-01-17)

## Description

L'invention a trait aux bicyclettes munies de systèmes de contrôle embarqués et aux systèmes automatiques de location comprenant de telles bicyclettes.

Plus particulièrement, l'invention concerne une bicyclette équipée d'un système de contrôle embarqué et d'une première interface de communication reliée électriquement au système de contrôle, ladite bicyclette comprenant au moins un organe fonctionnel.

Un exemple de bicyclette de ce type est divulgué dans le document WO-A-01/54080.

Le document US-B1-6 191 685 décrit une bicyclette selon le préambule de la revendication 1.
Aujourd'hui certaines villes sont équipées de systèmes automatisés de location de bicyclettes permettant à chaque citadin d'emprunter une bicyclette pour effectuer un parcours urbain.
La location peut s'effectuer sous certaines conditions de paiement et généralement contre caution, cette dernière condition visant à prémunir le loueur contre les vols et les éventuelles dégradations liées à l'utilisation quotidienne des bicyclettes.

Mais il s'avère également nécessaire de mettre en place des procédures de maintenance, afin de garantir aux usagers des bicyclettes en parfait état de marche.
Aujourd'hui, la maintenance est généralement effectuée par des techniciens qui effectuent des contrôles réguliers de chaque bicyclette.

Bien que souple, puisque faisant appel à la main-d'oeuvre humaine, une telle procédure est toutefois relativement complexe.

En effet, elle nécessite, pour chaque bicyclette, de connaître la position de celle-ci à la date indiquée par le planning, puis de se rendre sur place pour effectuer le contrôle de maintenance au cours duquel l'état de différents organes fonctionnels de la bicyclette est contrôle (notamment pneus, jantes, freins et feux).

En fonction de l'état de ces organes, la bicyclette peut être :
- soit immobilisée pour réparation en cas de défectuosité d'un organe ;
- soit remise en circulation lorsque l'état de la bicyclette est jugé satisfaisant.

On comprend aisément qu'au fur et à mesure que croît la taille de la flotte de bicyclettes (dans certaines villes, cette flotte peut comprendre plusieurs centaines de bicyclettes), ce type de procédure s'avère extrêmement complexe à organiser.

En outre, il peut arriver qu'une bicyclette soit victime d'une panne ou d'un dysfonctionnement sans qu'une opération de maintenance ne soit prévue dans l'immédiat. Comme il est rare que l'usager qui a été le témoin -ou l'acteur- d'une panne ou d'un dysfonctionnement prévienne de lui-même les services de maintenance du loueur, la bicyclette se trouve de fait immobilisée jusqu'à l'opération de maintenance suivante, car les usagers n'acceptent généralement pas d'utiliser une bicyclette défectueuse.

Il en résulte une perte de rentabilité dans l'exploitation de la flotte.

L'invention vise notamment à pallier les inconvénients précités, en proposant une bicyclette présentant une ergonomie améliorée et/ou dont la maintenance soit facilitée. L'invention vise également, dans un contexte tel que celui exposé ci-dessus, à simplifier la gestion d'une flotte de bicyclettes.

A cet effet, l'invention propose une bicyclette équipée d'un système de contrôle embarqué et d'une première interface de communication reliée électriquement au système de contrôle, ladite bicyclette comprenant au moins un organe fonctionnel,
caractérisée en ce que système de contrôle est adapté pour :
- contrôler l'état de l'organe fonctionnel, pour vérifier si une procédure de maintenance est nécessaire,
- et communiquer à une infrastructure fixe, via la première interface de communication, des informations d'état concernant l'état dudit organe fonctionnel.

Les informations d'état peuvent ensuite être traitées pour avertir un services de maintenance de l'existence d'un éventuel défaut et de la nécessité d'une intervention.

Il en résulte, d'une part, une ergonomie accrue de la bicyclette sur laquelle il n'est pas nécessaire d'effectuer les habituels contrôles de panne ou de défaillance puisqu'elle est équipée d'un système intégré de détection des pannes et, d'autre part, une amélioration sensible de la gestion d'une flotte comprenant de telles bicyclettes.

Dans des divers modes de réalisation de la bicyclette selon l'invention, on peut avoir recours en outre à l'une et/ou à l'autre des dispositions suivantes, utilisables le cas échéant indépendamment les unes des autres et/ou indépendamment des dispositions mentionnées ci-dessus :
- ladite première interface de communication comprend un émetteur/récepteur ;
- ledit première interface de communication est une interface de communication sans contact à courte portée ;
- le système de contrôle est adapté pour :
   - détecter un défaut dans le fonctionnement dudit organe fonctionnel, et
   - générer une information d'état caractéristique dudit défaut et communiquer cette information d'état à la première interface de communication pour être transmis à ladite infrastructure ;
- la bicyclette comporte un circuit principal d'éclairage arrière comprenant un premier feu arrière, le système de contrôle étant adapté pour :
   - commander ledit circuit principal d'éclairage arrière, et
   - détecter une défaillance dans ledit circuit principal d'éclairage arrière ;
- le circuit principal d'éclairage arrière comprend, en série, un amplificateur de courant, une diode électroluminescente, et un détecteur de courant ;
- la bicyclette comprend un circuit secondaire d'éclairage arrière indépendant du circuit principal d'éclairage arrière, ledit circuit secondaire d'éclairage arrière comprenant un deuxième feu arrière, et dans laquelle le système de contrôle est adapté pour commander le circuit secondaire d'éclairage arrière en le faisant fonctionner lorsqu'une défaillance a été détectée dans le circuit principal d'éclairage arrière ;
- la bicyclette comprend au moins un frein et un circuit secondaire d'éclairage arrière indépendant du circuit principal d'éclairage arrière, ledit circuit secondaire d'éclairage arrière comprenant un deuxième feu arrière, le système de contrôle étant adapté pour :
   - détecter l'actionnement du frein, et
   - commander le circuit secondaire d'éclairage arrière en le faisant fonctionner lorsque l'actionnement du frein a été détecté ;
- le circuit secondaire d'éclairage arrière comprend, en série, un amplificateur de courant, une diode électroluminescente, et un détecteur de courant ;
- la bicyclette comprend une dynamo, et le système de contrôle comprend une mémoire et est adapté pour :
   - mesurer une intensité électrique d'un courant généré par la dynamo,
   - inscrire sur la mémoire une information d'état caractéristique d'une défaillance du frein lorsque le système de contrôle détecte l'actionnement dudit frein sans détecter une diminution de ladite intensité électrique,
   - transmettre ladite information d'état caractéristique d'une défaillance du frein à la première interface de communication ;
- la bicyclette comprend deux circuits indépendants d'éclairage avant comportant chacun au moins un feu avant, et dans laquelle le système de contrôle est adapté pour :
   - alimenter en courant, à mi-puissance, chaque circuit d'éclairage avant,
   - détecter une défaillance dans l'un quelconque des circuits d'éclairage avant, et
   - alimenter l'un des circuits d'éclairage avant en courant, à pleine puissance, lorsque une défaillance a été détectée dans l'autre circuit ;
- chaque circuit d'éclairage avant comporte, en série, un amplificateur de courant, au moins une diode électroluminescente, et un détecteur de courant ;
- la bicyclette comprend :
   - au moins un circuit d'éclairage avant comportant au moins un feu avant,
   - au moins un circuit d'éclairage arrière comprenant un premier feu arrière,
   - une dynamo,
   - une batterie reliée électriquement à la dynamo pour être rechargée par ladite dynamo et alimentant au moins en partie les circuits d'éclairage avant et arrière,
   et le système de contrôle est adapté pour :
   - commander les circuits d'éclairage avant et arrière,
   - mesurer la charge de la batterie,
   - diminuer une intensité électrique alimentant les circuits d'éclairage avant lorsque la charge mesurée est inférieure à une valeur minimum prédéterminée ;
- la bicyclette comprend :
   - au moins un circuit d'éclairage avant comportant au moins un feu avant,
   - au moins un circuit d'éclairage arrière comprenant un premier feu arrière,
   - une dynamo,
   - une batterie reliée électriquement à la dynamo pour être rechargée par ladite dynamo et alimentant au moins en partie les circuits d'éclairage avant et arrière,
   et le système de contrôle comprend une horloge et est adapté pour :
   - commander les circuits d'éclairage avant et arrière,
   - détecter le fonctionnement de la dynamo,
   - couper lesdits circuits d'éclairage avant et arrière lorsque s'est écoulé un intervalle temporel de durée prédéterminée après un arrêt de fonctionnement de la dynamo ;
- le système de contrôle comprend une mémoire et est adapté pour :
   - recevoir un code d'identification par l'intermédiaire de la première interface de communication,
   - écrire ledit code d'identification dans la mémoire,
   - détecter un fonctionnement de la bicyclette,
   - en cas de fonctionnement de la bicyclette, comparer la valeur du code d'identification à au moins une valeur prédéterminée,
   - et en fonction de cette comparaison, déclencher ou non une réaction d'alarme ;
- le système de contrôle est adapté pour déclencher la réaction d'alarme lorsque la valeur du code d'identification correspond à ladite valeur prédéterminée ;
- le système de contrôle comprend une horloge et est adapté pour :
   - détecter un fonctionnement de la bicyclette,
   - après une durée prédéterminée de fonctionnement de la bicyclette, déclencher une réaction d'alarme ;
- la bicyclette comprend au moins un circuit d'éclairage qui comprend au moins un feu,
et le système de contrôle est adapté pour commander de manière intermittente le circuit d'éclairage à titre de réaction d'alarme ;
- la bicyclette comprend un haut-parleur commandé par le système de contrôle, et le système de contrôle est adapté pour faire émettre un signal sonore à ce haut-parleur à titre de réaction d'alarme ;
- le système de contrôle est adapté pour détecter un mouvement de la bicyclette et pour déterminer que la bicyclette est en fonctionnement lorsqu'un mouvement est détecté ;
- la bicyclette est verrouillable sur une borne fixe et le système de contrôle est adapté pour :
   - détecter un verrouillage de la bicyclette à une borne fixe,
   - faire émettre un signal d'acquit dès lors que le verrouillage de la bicyclette à la borne a été détecté ;
- la bicyclette comprend au moins un circuit d'éclairage commandé par le système de contrôle, et ledit système de contrôle est adapté pour faire fonctionner ledit circuit d'éclairage par intermittence pendant une durée limitée à titre de signal d'acquit.

L'invention a également pour objet une bicyclette comprenant au moins une dynamo, un frein et un système de contrôle embarqué adapté pour :
- détecter un actionnement du frein,
- mesurer une intensité électrique d'un courant généré par la dynamo,
- et repérer une défaillance du frein lorsque le système de contrôle détecte l'actionnement dudit frein sans détecter une diminution de ladite intensité électrique. Le système de contrôle peut comprendre alors éventuellement inscrire sur une mémoire une information d'état caractéristique de la défaillance du frein. De plus, la bicyclette peut comporter une première interface de communication et le système de contrôle peut être adapté pour communiquer à une infrastructure fixe, via la première interface de communication, ladite information d'état concernant la défaillance du frein.

L'invention a encore pour objet une bicyclette comprenant un système de contrôle embarqué comprenant une mémoire et relié à une première interface de communication, ledit système de contrôle étant adapté pour :
- recevoir un code d'identification d'une infrastructure fixe par l'intermédiaire de la première interface de communication,
- écrire ledit code d'identification dans la mémoire,
- détecter un fonctionnement de la bicyclette,
- en cas de fonctionnement de la bicyclette, comparer la valeur du code d'identification à au moins une valeur prédéterminée,
- et en fonction de cette comparaison, déclencher ou non une réaction d'alarme.

L'invention a aussi pour objet une bicyclette comprenant un système de contrôle embarqué comprenant une horloge et adapté pour :
- détecter un fonctionnement de la bicyclette,
- après une durée prédéterminée de fonctionnement de la bicyclette, déclencher une réaction d'alarme.

Par ailleurs, l'invention a également pour objet un système automatique de location de bicyclettes comprenant au moins une bicyclette telle que définie ci-dessus et une infrastructure adaptée pour recevoir lesdites informations d'état.

Dans des divers modes de réalisation du système de location de bicyclettes selon l'invention, on peut avoir recours en outre à l'une et/ou à l'autre des dispositions suivantes :
- le système automatique comporte une pluralité de bicyclettes et ladite infrastructure comporte :
   - une pluralité de postes de stockage adaptés pour recevoir sur chacun au moins une bicyclette aux fins de stockage,
   - et une pluralité de deuxièmes interfaces de communication à courte portée adaptées pour communiquer avec lesdites premières interfaces de communication des bicyclettes, chaque deuxième interface de communication de l'infrastructure étant associée à au moins un poste de stockage et disposée au voisinage immédiat dudit poste de stockage ;
- chaque poste de stockage comprend une borne fixe ;
- la borne fixe comprend une desdites deuxièmes interfaces de communication ;
- ladite deuxième interface de communication est une interface de communication sans contact comprenant un émetteur/récepteur ;
- l'infrastructure comporte en outre au moins un poste central centralisant lesdites informations d'état reçues par toutes les deuxièmes interfaces de communication.

D'autres objets et avantages de l'invention apparaîtront à la lumière de la description faite ci-après en référence aux dessins annexés dans lesquels :
- la figure 1 est une vue d'élévation de côté d'une bicyclette selon l'invention, munie d'un système de contrôle embarqué ; la bicyclette est représentée dans une position remisée où elle est temporairement fixée à une borne fixe,

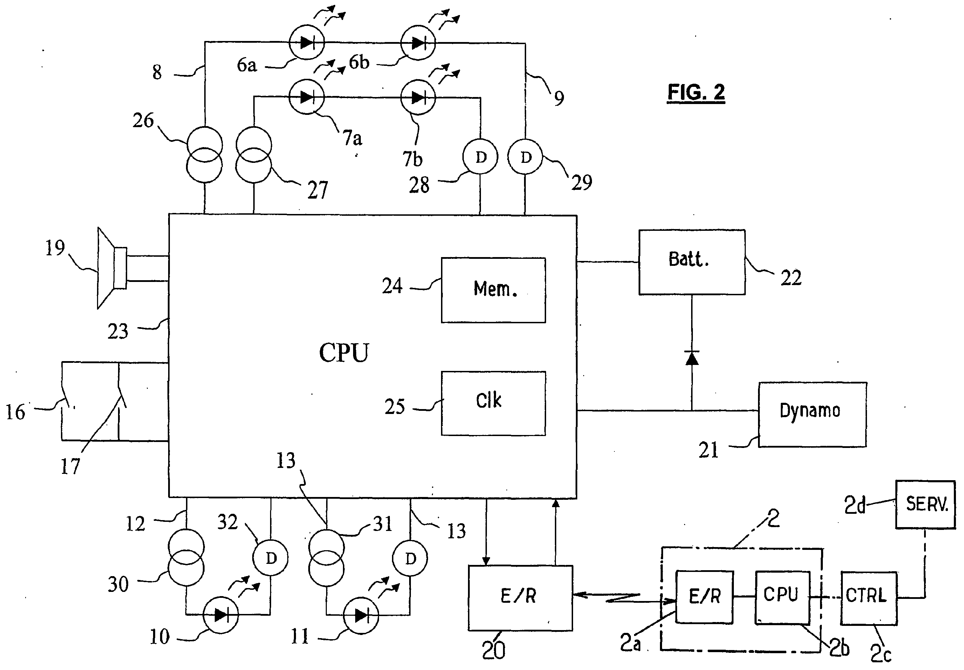

- la figure 2 est un schéma illustrant le système de contrôle embarqué de la bicyclette de la figure 1 et une partie de l'infrastructure fixe du système de location de bicyclettes,
- les figures 3 à 9 sont des diagrammes illustrant diverses opérations de contrôle effectuées sur des organes fonctionnels de la bicyclette.

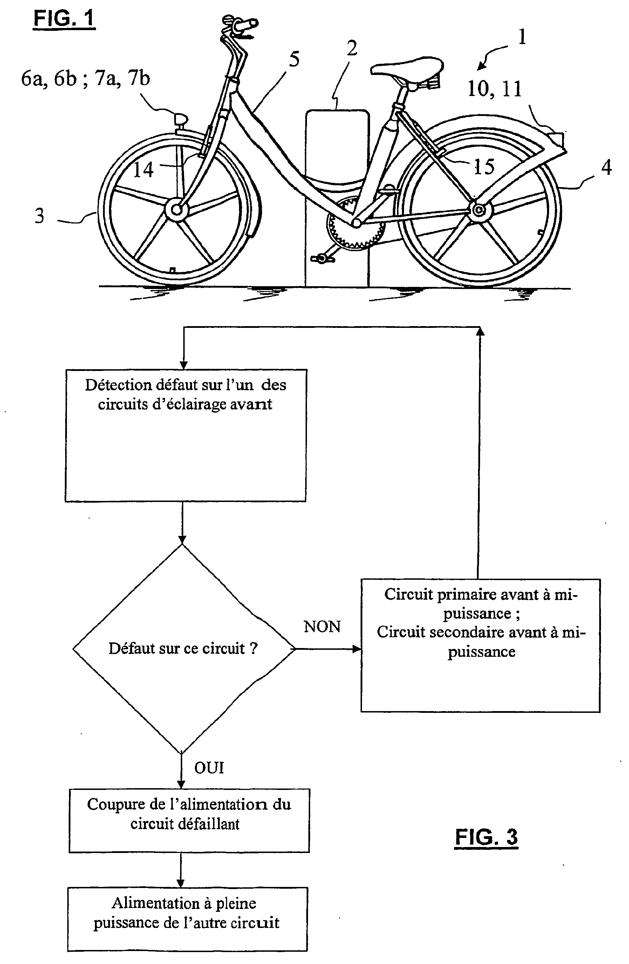

Sur la figure 1 est représentée une bicyclette 1 appartenant à une flotte de bicyclettes proposées à la location en milieu urbain. Cette flotte de bicyclettes 1 fait partie d'un système de location automatique de bicyclettes qui comprend en outre une infrastructure fixe incluant notamment des bornes fixes 2 ou autres postes de stockage de bicyclettes sur lesquelles les bicyclettes peuvent se verrouiller en attente d'être empruntées.

La bicyclette 1 est ici représentée dans une position remisée où elle est fixée temporairement à une borne 2 de stockage, laquelle est munie d'un système de verrouillage (non représenté) qui coopère avec des moyens d'accrochage (non représentés) prévus sur la bicyclette 1 pour empêcher son utilisation par une personne non autorisée.

A la demande d'un utilisateur ayant suivi une procédure de location incluant éventuellement une étape de paiement, le système de verrouillage peut être désactivé pour permettre à l'utilisateur de disposer de la bicyclette 1 pour une période prédéterminée.

Une procédure de location d'une bicyclette, une borne et ses moyens de verrouillage sont décrits en détails dans les demandes internationales publiées sous les numéro WO-02/095698 et WO-01/54080 au nom de la demanderesse, à laquelle l'homme du métier pourra se référer.

La bicyclette 1 comprend une roue avant 3, une roue arrière 4 montées toutes deux à rotation sur un cadre 5. Cette bicyclette 1 est en outre équipée :
- de deux paires de feux avant 6a, 6b, 7a, 7b montés sur deux circuits électriques séparés, à savoir un circuit avant primaire 8 et un circuit avant secondaire 9, chaque paire de feux comprenant, d'une part, un feu avant bâbord 6a, 7a, destiné à éclairer du côté gauche de la bicyclette 1 et, d'autre part, un feu avant 6b, 7b tribord, destiné à éclairer du côté droit de la bicyclette 1 ;
- de deux feux arrière 10, 11 appartenant respectivement à deux circuits électriques séparés, à savoir un circuit arrière primaire 12, et un circuit arrière secondaire 13 ;
- de deux freins, à savoir un frein avant 14 destiné à enserrer la roue avant 3 et un frein arrière 15 destiné à enserre la roue arrière 4, ces freins 14, 15 étant reliés à deux interrupteurs 16, 17 montés en parallèle sur un circuit électrique 18, chaque interrupteur 16, 17 étant à l'état ouvert lorsque le frein correspondant 14, 15 est au repos, et à l'état fermé lorsque le frein correspondant 14, 15 est actionné ;
- d'un haut-parleur 19 ;
- d'une première interface de communication 20 sans contact à courte portée, par exemple un émetteur/récepteur d'ondes radio ; cette première interface de communication est adaptée pour communiquer avec une deuxième interface de communication 2a identique ou similaire appartenant à l'infrastructure fixe du système de location de bicyclettes, cette deuxième interface de communication pouvant par exemple être incluse dans la borne 2 et étant reliée à une unité centrale électronique 2b (CPU) elle-même éventuellement incluse dans la borne 2, et l'unité centrale 2b communiquant avec un serveur central 2d (SERV.) commun à tout ou partie des bornes 2 du système (éventuellement, les bornes 2 situées en même lieu peuvent communiquer avec une borne de commande comprenant une unité centrale de commande 2c (CTRL) elle-même reliée au serveur 2d) ;
- d'une dynamo 21, montée sur l'une des roues 3, 4, et
- d'une batterie d'accumulateurs 22 (Batt.).

Chacun des éléments susmentionnés de la bicyclette est relié électriquement à un processeur 23 (également appelé CPU suivant la terminologie internationale consacrée) alimenté électriquement par la dynamo 21 qui, lorsque la bicyclette 1 est en mouvement, assure la charge de la batterie 22.

Le CPU 23 comporte une mémoire flash 24 (Mem.) dans laquelle, comme nous le verrons par la suite, sont stockées des données relatives à l'état de la bicyclette 1, ainsi qu'une horloge interne 25 (Clk) dont l'utilité apparaîtra ci-après. Le CPU 23 forme un système de contrôle embarqué, apte à gérer le fonctionnement de certaines organes de la bicyclette 1 et à détecter d'éventuelles pannes.

La dynamo 21 peut par exemple être intégrée dans le moyeu de l'une des roues, par exemple la roue avant 3, à des fins de compacité et pour éviter les éventuelles dégradations auxquelles sont exposées les classiques dynamos à friction.

Des brevets ont été déposés par le passé pour de telles dynamos intégrées dans un moyeu. L'homme du métier pourra s'y référer.

Comme cela est visible sur la figure 1, chaque feu avant 6a, 6b, 7a, 7b peut par exemple être constitué par une diode électroluminescente (également appelée LED conformément à la pratique internationale).

Afin de garantir une bonne luminosité des LED (et par conséquent une bonne visibilité de la bicyclette), chaque circuit avant 8, 9 comporte un amplificateur de courant 26, 27 en sortie du CPU 23. Chaque circuit avant 8, 9 comporte également un détecteur de courant 28, 29 pour mesurer le courant circulant dans le circuit.

Ainsi chaque circuit avant 8, 9 comporte, en série, successivement et dans le sens du courant : un amplificateur de courant26, 27, deux LED 6a, 6b, 7a, 7b et un détecteur de courant 28, 29.

Le fonctionnement de l'éclairage avant est géré par le système de contrôle 23, de la manière suivante (se reporter à la figure 3).

Le CPU 23 commence par vérifier si la bicyclette 1 est en mouvement (cette vérification peut être effectuée au moyen d'un roulement instrumenté dont est équipé le moyeu de l'une des roues 3, 4, roulement relié électriquement au CPU 23, ou au moyen d'un signal de charge de la dynamo 21).

Tant que le CPU 23 détecte que la bicyclette 1 est en mouvement, il alimente en courant d'intensité constante, produit par la dynamo 21, les circuits primaire et secondaire 8, 9.

Par ailleurs, tant que le CPU 23 détecte que la bicyclette 1 est en mouvement, il détecte à chaque instant si un défaut apparaît dans l'un des circuits primaire ou secondaire 8, 9.

Tant qu'aucun défaut n'est décelé, le CPU 23 alimente les circuits 8, 9 en un courant dont l'intensité, dite intensité normale, représente une partie seulement de l'intensité maximale admissible par les LED 6a, 6b, 7a, 7b. Suivant un mode particulier de réalisation, cette intensité normale est égale à la moitié seulement de l'intensité maximale admissible. Autrement dit, les circuits 8, 9 sont alimentés à mi-puissance. Compte tenu de la présence de quatre LED 6a, 6b, 7a, 7b et de la répartition de part et d'autre de la bicyclette 1 -à bâbord et à tribord-, la qualité de l'éclairage ne pâtit pas de cette alimentation à mi-puissance, tandis que des économies sensibles d'énergie sont réalisées.

Par contre, lorsqu'un défaut apparaît, pour une raison ou pour une autre (par exemple lorsqu'une LED est défaillante), il est immédiatement décelé par le détecteur de courant 28, 29, qui mesure alors une variation d'intensité dans le circuit correspondant 8, 9.

Le CPU 23 coupe alors immédiatement l'alimentation du circuit défaillant (par exemple le circuit primaire 8) et fait passer l'intensité du courant d'alimentation de l'autre circuit (en l'occurrence le circuit secondaire 9) à sa valeur maximale admissible (en d'autres termes, ce circuit est alimenté à pleine puissance).

Le CPU 23 génère alors un signal caractéristique du défaut décelé, à destination de la mémoire flash 24, dans laquelle est alors stocké un identifiant caractéristique de l'état défaillant du circuit concerné.

Lorsque la bicyclette 1 est rendue par son utilisateur qui vient la verrouiller sur une borne 2 libre, le CPU 23 interroge la mémoire 24 et, lorsque celle-ci contient un identifiant caractéristique d'un défaut dans un circuit d'éclairage avant 8, il communique à la borne 2, via l'émetteur/récepteur 20, un message d'erreur à l'attention de la maintenance afin de prévenir celle-ci qu'une intervention est nécessaire sur l'éclairage avant. La location de la bicyclette 1 peut être condamnée tant que cette intervention n'a pas été effectuée.

Les circuits d'éclairage arrière 12, 13 peuvent par exemple être identiques ou similaires aux circuits d'éclairage avant 8, 9, si ce n'est que chaque circuit d'éclairage arrière ne comprend qu'une LED, et que cette LED est de plus faible puissance que les LED de l'éclairage avant.

Afin de garantir une bonne luminosité des LED 6a, 6b, 7a, 7b, chaque circuit arrière 12, 13 comporte un amplificateur de courant 30, 31 en sortie du CPU 23, et un détecteur de courant 32, 33 pour mesurer le courant circulant dans le circuit 12, 13.

Ainsi, chaque circuit arrière comporte-t-il, en série, successivement et dans le sens du courant : un amplificateur de courant 30, 31, une LED 10, 11 et un détecteur de courant 32, 33.

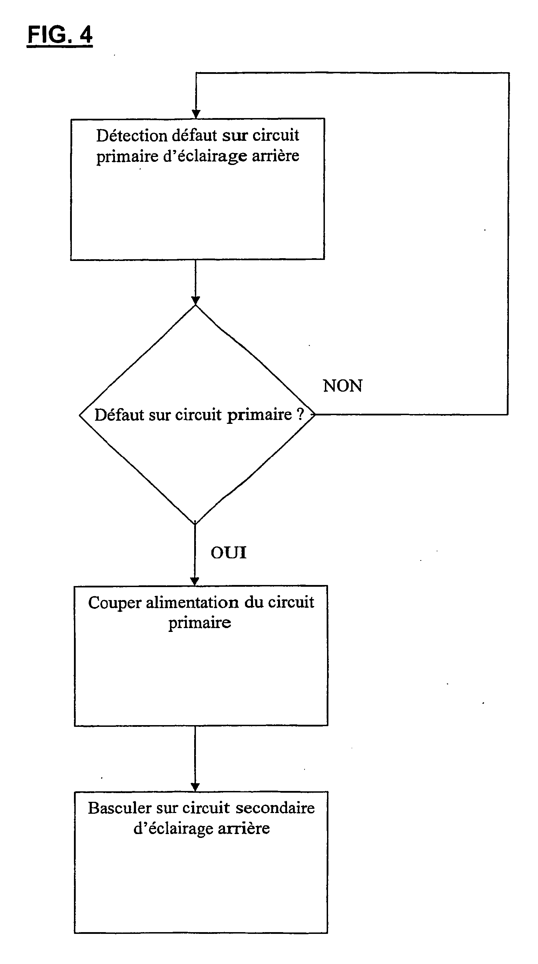

Le fonctionnement de l'éclairage arrière est géré par le système de contrôle 23, de la manière suivante (se reporter à la figure 4).

Le CPU 23 commence par vérifier si la bicyclette 1 est en mouvement, de la même manière que pour l'éclairage avant (voir supra).

Tant que le CPU 23 détecte que la bicyclette 1 est en mouvement, il alimente en courant d'intensité constante, produit par la dynamo 21, le circuit primaire 12, tandis que le circuit secondaire 13, qui constitue un circuit de secours, n'est pas alimenté.

Par ailleurs, tant que le CPU 23 détecte que la bicyclette 1 est en mouvement, il détecte à chaque instant si un défaut apparaît dans le circuit primaire 12.

Tant qu'aucun défaut n'est décelé, le circuit primaire 12 est alimenté en courant par le CPU 23.

Par contre, lorsqu'un défaut apparaît dans le circuit primaire 12, il est immédiatement décelé par le détecteur de courant 32.

Le CPU 23 coupe alors immédiatement l'alimentation du circuit primaire 12 (défaillant) et alimente en courant le circuit secondaire 13 qui prend le relais.

Le CPU 23 génère alors un signal caractéristique du défaut décelé, à destination de la mémoire flash 24, dans laquelle est alors stocké un identifiant caractéristique de l'état défaillant du circuit primaire 12.

Lorsque la bicyclette 1 est rendue par son utilisateur qui vient la verrouiller sur une borne 2 libre, le CPU 23 interroge la mémoire 24 et, lorsque celle-ci contient un identifiant caractéristique d'un défaut dans le circuit primaire d'éclairage arrière 12, il communique à la borne, via l'émetteur/récepteur 20, un message d'erreur à l'attention de la maintenance afin de prévenir celle-ci qu'une intervention est nécessaire sur l'éclairage arrière. La location de la bicyclette 1 n'est pas forcément condamnée, tant que le circuit secondaire 13 ne s'avère pas lui aussi défaillant. Mais la procédure de contrôle automatique de l'état du circuit secondaire 13 est alors répétée de la même façon que précédemment décrit pour le circuit primaire 12.

Et, lorsque le circuit secondaire 13 se révèle défaillant à son tour, la bicyclette 1 peut être condamnée tant qu'une intervention n'a pas été effectuée sur l'un et/ou l'autre des circuits 12, 13.

Par ailleurs, dès lors que l'immobilité de la bicyclette 1 est détectée par le CPU 23 (par exemple lorsque la bicyclette 1 est arrêtée à un feu de circulation ou lorsqu'elle est remisée après avoir été rendue par son locataire), le CPU 23 commande un décompte au moyen de l'horloge 25 (par exemple de l'ordre de 30 secondes).

Pendant ce décompte, l'alimentation électrique du CPU 23 est assurée automatiquement par la batterie 22, sur laquelle bascule la dynamo 21 alors à l'arrêt.

Si, avant la fin du décompte, le CPU 23 détecte un mouvement de la bicyclette 1 (par exemple si le conducteur démarre après avoir été temporairement immobilisé à un feu de circulation), l'alimentation du CPU 23 bascule de nouveau sur la dynamo 21 et le processus est relancé.

Si par contre le décompte arrive à terme sans que le CPU 23 ait détecté un mouvement de la bicyclette 1, le CPU commande l'extinction des feux, tant avant 6a, 6b, 7a, 7b qu'arrière 10, 11, afin de réaliser des économies d'énergie et ne pas décharger la batterie 22.

Grâce au système de contrôle 23 embarqué, il est également possible de détecter de manière automatique une utilisation frauduleuse (c'est-à-dire résultant du vol de la bicyclette) ou abusive (c'est-à-dire un usage de la bicyclette 1 au-delà d'une période d'emprunt prédéterminée à l'expiration de laquelle l'usager aurait dû rendre la bicyclette 1).

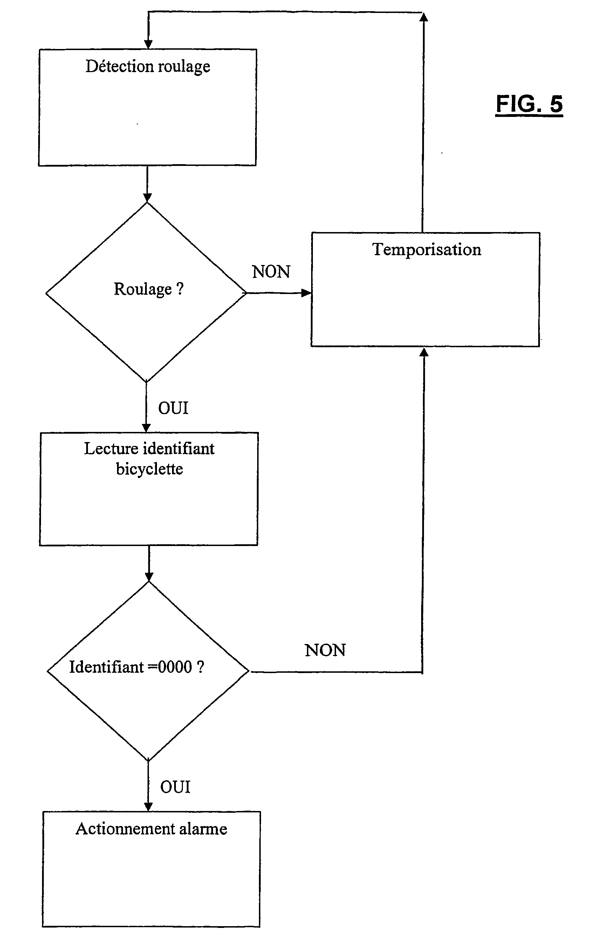

Afin de prévenir une utilisation frauduleuse (se reporter à la figure 5), il est associé à la bicyclette 1 un identifiant général stocké dans la mémoire 24. Lorsque la bicyclette 1 est remisée, ce que le CPU 23 peut détecter au moyen d'un signal reçu du système de verrouillage de la borne 2 lorsque celui-ci est activé, à l'identifiant général est attribué une valeur prédéterminée indépendante de l'utilisateur, par exemple la valeur nulle (0000).

Lorsque l'utilisateur a correctement effectué les étapes de location de la bicyclette 1, celle-ci s'est vue attribuer un identifiant correspondant à l'utilisateur (auquel correspond une valeur mémorisée non nulle).

Le CPU 23 détecte si la bicyclette est en mouvement. Si tel n'est pas le cas, le CPU 23 commande une temporisation au moyen de l'horloge 25 (par exemple un décompte d'une dizaine de minutes) avant de renouveler la détection.

Dès lors que le mouvement de la bicyclette 1 est détecté, le CPU 23 lit l'identifiant mémorisé.

Si cet identifiant est non nul, la procédure est répétée.

Dès lors que l'identifiant est nul, ce qui signifie que la bicyclette 1 a été empruntée de manière frauduleuse, le CPU 23 actionne une alarme sonore et/ou visuelle.

Par exemple, le CPU 23 peut alors alimenter en courant le haut parleur 19 qui produit un bruit de sirène afin d'attirer les regards sur la bicyclette 1 et, surtout, sur son usager frauduleux. Les feux avant 6a, 6b, 7a, 7b et/ou arrière 10, 11 peuvent, indépendamment ou simultanément, être éclairés de manière intermittente afin que le clignotement ainsi produit attire également les regards et incite l'usager frauduleux à se séparer de la bicyclette.

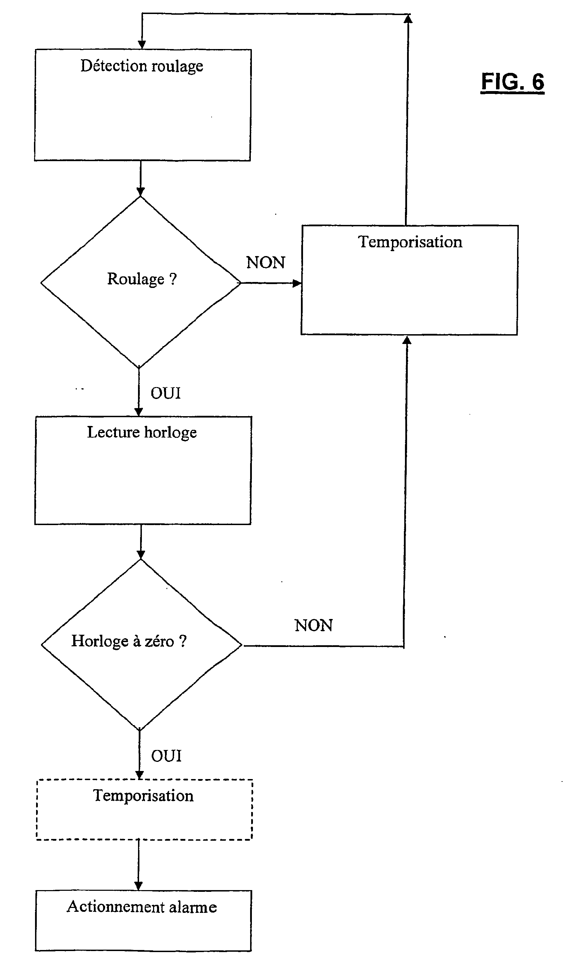

Afin par ailleurs de détecter toute utilisation abusive (se reporter à la figure 6),-le CPU 23 détecte à chaque instant si la bicyclette 1 est en mouvement. Au moment de l'emprunt de la bicyclette 1, le CPU 23 génère dans l'horloge 25 un décompte pour une période d'une durée prédéterminée (par exemple 4 heures).

Si le décompte parvient à terme avant que le CPU 23 n'ait détecté le verrouillage de la bicyclette 1, ce qui signifie que la bicyclette 1 est utilisée au-delà de la période autorisée, le CPU 23 actionne une alarme sonore et/ou visuelle, de la même manière que décrit ci-dessus pour l'utilisation frauduleuse de la bicyclette.

Le CPU 23 peut ne pas déclencher immédiatement l'alarme, mais commander une temporisation au moyen de l'horloge 25, et ne déclencher l'alarme qu'à la fin de cette temporisation (dont la durée est par exemple égale à quatre fois la durée de la période autorisée), de manière à autoriser à l'utilisateur de bonne foi un certain retard (par exemple pour lui laisser le temps de trouver une borne libre lorsque toutes les bornes situées à proximité de sa destination sont occupées).

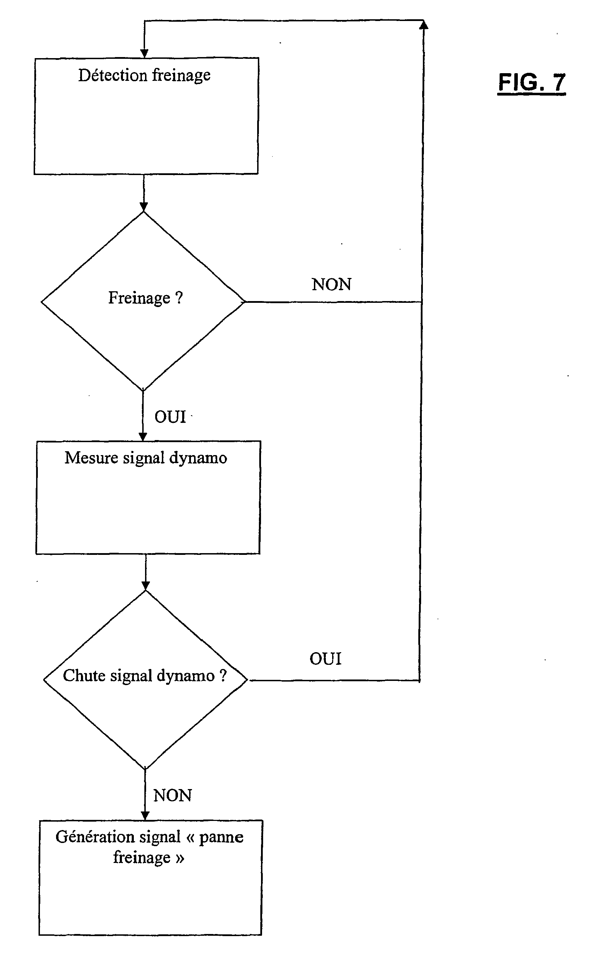

Par ailleurs, grâce au système de contrôle embarqué 23, il est également possible de détecter toute défaillance des freins 14, 15 (se reporter à la figure 7).

Suivant un mode de réalisation illustré sur la figure 1, les freins avant 14 et arrière 15 sont reliés respectivement à un interrupteur avant 16 et un interrupteur arrière 17 montés en parallèle sur un circuit 18 relié électriquement au CPU 23.

Ces interrupteurs 16, 17, normalement ouverts, se ferment lorsque le frein avant 14 ou, respectivement, le frein arrière 15 sont actionnés, de sorte que le CPU 23 détecte immédiatement le freinage de la bicyclette 1.

Dès lors que ce freinage est détecté, le CPU 23 alimente en courant le circuit secondaire d'éclairage arrière 13, de manière à éclairer la LED 11 correspondante, qui agit ainsi à la manière d'un feu stop (tandis que, comme nous l'avons vu ci-dessus, le feu arrière principal agit à la manière d'un feu de position).

Il en résulte une meilleure sécurité du cycliste, les éventuelles automobiles ou les éventuels cyclistes qui se trouvent derrière lui étant prévenus du freinage.

Simultanément, le CPU 23 contrôle que la valeur de l'intensité du courant d'alimentation en provenance de la dynamo 21 se met à chuter, ce qui est l'indice d'une décroissance de la vitesse de la bicyclette 1.

Dès lors que le CPU 23 détecte l'actionnement des freins 14, 15 sans détecter simultanément une chute de la valeur de l'intensité de la dynamo 21, ce qui signifie que les freins 14, 15 ne remplissent pas leur fonction, le CPU 23 génère un signal caractéristique d'un défaut de freinage, et inscrit dans la mémoire flash 24 un identifiant caractéristique de l'état défaillant du freinage.

Lorsque la bicyclette 1 est rendue par son utilisateur qui vient la verrouiller sur une borne 2 libre, le CPU 23 interroge la mémoire et, lorsque celle-ci contient un identifiant caractéristique d'un défaut de freinage, il communique à la borne 2, via l'émetteur/récepteur 20, un message d'erreur à l'attention de la maintenance afin de prévenir celle-ci qu'une intervention est nécessaire sur les freins 14, 15. Compte tenu de l'importance du freinage, la location de la bicyclette 1 est alors condamnée tant que cette intervention n'a pas été effectuée.

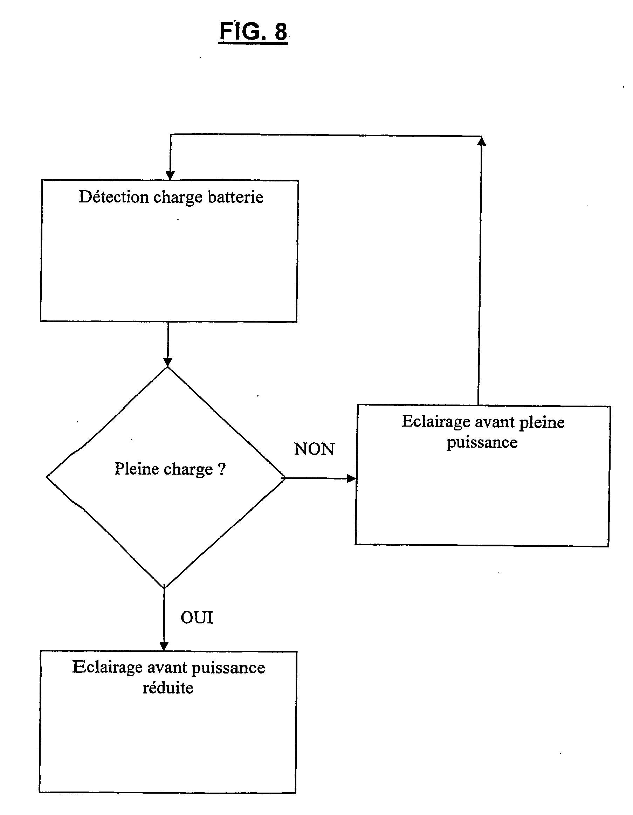

Grâce au système de contrôle embarqué 23, il est en outre possible de détecter toute défaillance de la dynamo 21 et de donner priorité à la charge de la batterie 22 sur l'éclairage (se reporter à la figure 8).

A cet effet, le CPU détecte à chaque instant la charge de la batterie (par exemple en mesurant la valeur de l'intensité en sortie de batterie).

Tant que la batterie 22 est à pleine charge et que le CPU 23 détecte que la bicyclette 1 est en mouvement, les circuits d'éclairage avant 8, 9 sont alimentés de manière normale, tel que décrit ci-dessus.

Par contre, dès lors que le CPU 23 détecte une décharge de la batterie 22, priorité est donnée à sa charge sur l'éclairage. A cet effet, le CPU 23 diminue la valeur de l'intensité du courant fourni aux circuits d'éclairage avant 8, 9, afin d'accroître la valeur de l'intensité du courant fourni par la dynamo 21 à la batterie 22.

Dès que la charge de la batterie 22 est complète, le CPU 23 alimente à nouveau normalement les circuits d'éclairage 8, 9.

Il est ainsi possible de charger plus rapidement la batterie 22, au bénéfice de la sécurité de la bicyclette 1. Au moment où la bicyclette 1 est rendue par son locataire, le niveau de charge de la batterie 22, inscrit au préalable sur la mémoire flash 24, est communiqué, via l'émetteur/récepteur 20, à la borne 2 qui, dès lors que ce niveau de charge est inférieur à un niveau minimum autorisé prédéterminé, transmet à l'attention de la maintenance un signal afin de prévenir celle-ci qu'une intervention est nécessaire sur la batterie 22 ou sur la dynamo 21. Il est possible de condamner la location de la bicyclette 1 tant que cette intervention n'a pas été effectuée.

Le système de contrôle embarqué 23 peut également être mis à profit pour informer l'utilisateur de la bonne marche des opérations, notamment lors de l'emprunt et de la remise de la bicyclette 1.

Ainsi, lorsque le CPU 23 détecte, lors de l'emprunt de la bicyclette 1, la séparation d'avec la borne 2, il alimente temporairement (par exemple pendant quelques secondes) les circuits d'éclairage 8, 9 de manière intermittente, afin de générer un clignotement qui avertit l'utilisateur que la bicyclette 1 est effectivement disponible.

De manière analogue, lorsque le locataire rend la bicyclette 1 après utilisation, le CPU 23 détecte si le verrouillage sur la borne 2 a été correctement effectué, et, si tel est le cas, alimente temporairement les circuits d'éclairage 8, 9 pour générer un clignotement avertissant le locataire que la remise de la bicyclette a été effectuée correctement. Le CPU 23 attribue alors la valeur nulle 0000 à l'identifiant général de la bicyclette 1. Cette valeur est inscrite dans la mémoire flash 24.

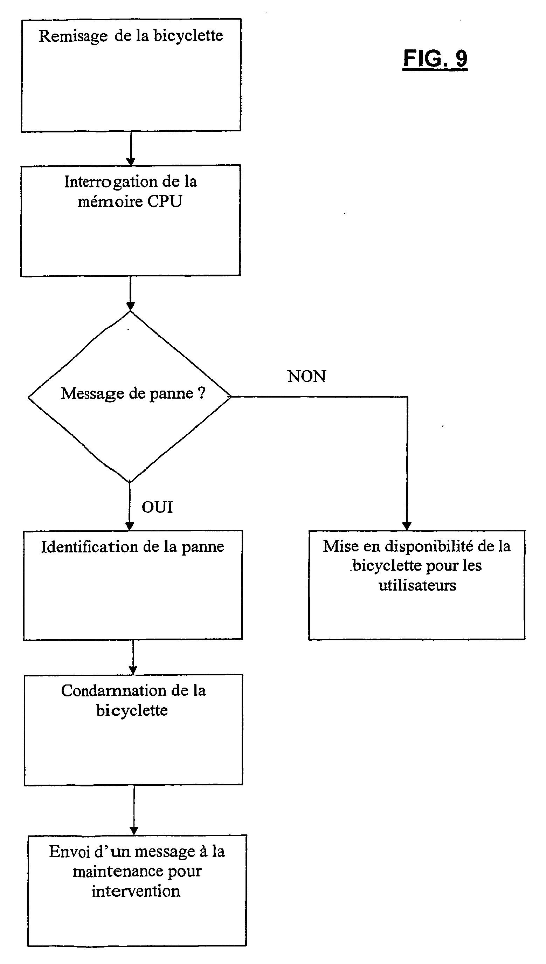

Ainsi, globalement, la procédure suivie lors de la remise de la bicyclette 1 par le locataire est la suivante (on se reportera à la figure 9).

Le CPU 23 détecte si le verrouillage de la bicyclette 1 sur la borne 2 a été correctement effectué. Si tel n'est pas le cas, le CPU 23 peut en avertir le locataire en déclenchant une alarme, par exemple en alimentant le haut-parleur 19 qui émet temporairement un bruit de sirène, continue ou par à-coups.

Si, au contraire, le verrouillage a été correctement effectué, le CPU 23 communique à la borne 2, via l'émetteur/récepteur 20, les données inscrites dans la mémoire flash 24.

Comme nous l'avons vu ci-dessus, ces données peuvent contenir des identifiants caractéristiques :
- d'une défaillance de l'un ou de plusieurs des circuits d'éclairage avant 8 ou arrière 9 ;
- d'une défaillance des freins 14, 15 ;
- d'une charge incomplète de la batterie 22 ou d'une défaillance de la dynamo 21.

Si tel est le cas, la borne 2 identifie la panne ou la défaillance correspondante, bloque, lorsque cela est nécessaire, son système de verrouillage afin de condamner l'utilisation ultérieure de la bicyclette 1, et transmet à la maintenance un message requérant une intervention sur l'organe défaillant ou en panne.

Dès lors que l'intervention a été faite et que la bicyclette 1 est à nouveau en ordre de marche, la mémoire flash 24 est réinitialisée (de préférence par un technicien de la maintenance), par exemple en actionnant un bouton « réinitialisation » sur le boîtier du CPU 23 et la bicyclette 1 est immédiatement mise en disponibilité pour la location.

Si la mémoire flash 24 ne contient aucun identifiant caractéristique d'une panne ou d'une défaillance, la bicyclette 1 est immédiatement mise en disponibilité pour une location ultérieure.

Il résulte de ce qui vient d'être décrit une meilleure ergonomie, du point de vue de l'usager, tant de la bicyclette 1 elle-même que, dans le contexte d'un système locatif, de ce système.

Par ailleurs, l'utilisation du système de contrôle embarqué 23, propre à chaque bicyclette 1, simplifie considérablement la gestion d'une flotte de bicyclettes -surtout lorsque cette flotte est nombreuse- en systématisant la détection de toute panne ou défaillance des organes principaux de chaque bicyclette et en faisant intervenir la maintenance lorsque cela est nécessaire.

Il n'est pas nécessaire à la maintenance de localiser toute bicyclette défectueuse puisque la borne à laquelle cette bicyclette est fixée est clairement identifiée.

L'application d'un système de contrôle embarqué n'est pas limitée aux exemples donnés ci-dessus. Ainsi, l'on pourrait prévoir de détecter tout dégonflement ou toute crevaison d'un pneu au moyen de détecteurs de pression reliés électriquement au CPU, la procédure suivie en cas de défaillance étant la même que celle décrite précédemment pour les défaillances des circuits d'éclairage, des freins, de dynamo ou de batterie.

Par ailleurs, le fonctionnement du CPU 23 en accord avec les procédures décrites ci-dessus peut être assuré au moyen d'une programmation appropriée, à la portée de l'homme du métier.

## Revendications

1. Bicyclette équipée d'un système de contrôle embarqué (23) et d'une première interface de communication (20) reliée électriquement au système de contrôle (23), ladite bicyclette comprenant au moins un organe fonctionnel (6a, 6b, 7a, 7b ; 10, 11 ; 14, 15 ; 21, 22),
**caractérisée en ce que** ledit système de contrôle est adapté pour :
- contrôler l'état de l'organe fonctionnel (6a, 6b, 7a, 7b ; 10, 11 ; 14, 15 ; 21, 22), pour vérifier si une procédure de maintenance est nécessaire,
- et communiquer à une infrastructure fixe (2, 2c, 2d), via la première interface de communication (20), des informations d'état concernant l'état dudit organe fonctionnel (6a, 6b, 7a, 7b ; 10, 11 ; 14, 15 ; 21, 22).

2. Bicyclette selon la revendication 1, dans laquelle ladite première interface de communication comprend un émetteur/récepteur (20).

3. Bicyclette selon la revendication 2, dans laquelle ledit première interface de communication (20) est une interface de communication sans contact à courte portée.

4. Bicyclette selon l'une quelconque des revendications précédentes, dans laquelle le système de contrôle (23) est adapté pour :
- détecter un défaut dans le fonctionnement dudit organe fonctionnel (6a, 6b, 7a, 7b ; 10, 11 ; 14, 15 ; 21, 22), et
- générer une information d'état caractéristique dudit défaut et communiquer cette information d'état à la première interface de communication (20) pour être transmis à ladite infrastructure (2, 2c, 2d).

5. Bicyclette selon l'une quelconque des revendications précédentes, comportant un circuit principal d'éclairage arrière (12) comprenant un premier feu arrière (10), le système de contrôle (23) étant adapté pour :
- commander ledit circuit principal d'éclairage arrière (12), et
- détecter une défaillance dans ledit circuit principal d'éclairage arrière (12).

6. Bicyclette selon la revendication 5, dans laquelle le circuit principal d'éclairage arrière (12) comprend, en série, un amplificateur de courant (30), une diode électroluminescente (10), et un détecteur de courant (32).

7. Bicyclette selon la revendication 5 ou la revendication 6, comprenant un circuit secondaire d'éclairage arrière (13) indépendant du circuit principal d'éclairage arrière (12), ledit circuit secondaire d'éclairage arrière (13) comprenant un deuxième feu arrière (11), et dans laquelle le système de contrôle (23) est adapté pour commander le circuit secondaire d'éclairage arrière (13) en le faisant fonctionner lorsqu'une défaillance a été détectée dans le circuit principal d'éclairage arrière (12).

8. Bicyclette selon l'une quelconque des revendications 5 à 7, comprenant au moins un frein (14, 15) et un circuit secondaire d'éclairage arrière (13) indépendant du circuit principal d'éclairage arrière (12), ledit circuit secondaire d'éclairage arrière (13) comprenant un deuxième feu arrière (11), le système de contrôle étant adapté pour :
- détecter l'actionnement du frein (14, 15), et
- commander le circuit secondaire d'éclairage arrière (13) en le faisant fonctionner lorsque l'actionnement du frein (14, 15) a été détecté.

9. Bicyclette (1) selon l'une quelconque des revendications 7 et 8, dans laquelle le circuit secondaire d'éclairage arrière (13) comprend, en série, un amplificateur de courant (31), une diode électroluminescente (11), et un détecteur de courant (33).

10. Bicyclette selon l'une quelconque des revendications précédentes, comprenant au moins un frein (14, 15) et une dynamo (21), et dans laquelle le système de contrôle (23) comprend une mémoire (24) et est adapté pour :
- détecter un actionnement du frein (14, 15),
- mesurer une intensité électrique d'un courant généré par la dynamo (21),
- inscrire sur la mémoire (24) une information d'état caractéristique d'une défaillance du frein (14, 15) lorsque le système de contrôle (23) détecte l'actionnement dudit frein (14, 15) sans détecter une diminution de ladite intensité électrique,
- transmettre ladite information d'état caractéristique d'une défaillance du frein à la première interface de communication (20).

11. Bicyclette selon l'une quelconque des revendications précédentes, comprenant deux circuits indépendants d'éclairage avant (8, 9) comportant chacun au moins un feu avant (6a, 6b ; 7a, 7b), et dans laquelle le système de contrôle (23) est adapté pour :
- alimenter en courant, à mi-puissance, chaque circuit d'éclairage avant (8, 9),
- détecter une défaillance dans l'un quelconque des circuits d'éclairage avant (8, 9), et
- alimenter l'un des circuits d'éclairage avant (8, 9) en courant, à pleine puissance, lorsque une défaillance a été détectée dans l'autre circuit.

12. Bicyclette selon la revendication 11, dans laquelle chaque circuit d'éclairage avant (8, 9) comporte, en série, un amplificateur de courant (26, 27), au moins une diode électroluminescente (6a, 6b ; 7a, 7b), et un détecteur de courant (28, 29).

13. Bicyclette selon l'une quelconque des revendications précédentes, comprenant :
- au moins un circuit d'éclairage avant (8, 9) comportant au moins un feu avant (6a, 6b ; 7a, 7b),
- au moins un circuit d'éclairage arrière (12, 13) comprenant un premier feu arrière (10, 11),
- une dynamo (21),
- une batterie (22) reliée électriquement à la dynamo (21) pour être rechargée par ladite dynamo et alimentant au moins en partie les circuits d'éclairage avant et arrière (8, 9, 12, 13),
dans laquelle le système de contrôle (23) est adapté pour :
- commander les circuits d'éclairage avant et arrière (8, 9, 12, 13),
- mesurer la charge de la batterie (22),
- diminuer une intensité électrique alimentant les circuits d'éclairage avant (8, 9) lorsque la charge mesurée est inférieure à une valeur minimum prédéterminée.

14. Bicyclette selon l'une quelconque des revendications précédentes, comprenant :
- au moins un circuit d'éclairage avant (8, 9) comportant au moins un feu avant (6a, 6b ; 7a, 7b),
- au moins un circuit d'éclairage arrière (12, 13) comprenant un premier feu arrière (10, 11),
- une dynamo (21),
- une batterie (22) reliée électriquement à la dynamo (21) pour être rechargée par ladite dynamo et alimentant au moins en partie les circuits d'éclairage avant et arrière (8, 9, 12, 13),
dans laquelle le système de contrôle (23) comprend une horloge (25) et est adapté pour :
- commander les circuits d'éclairage avant et arrière (8, 9, 12, 13),
- détecter le fonctionnement de la dynamo (21),
- couper lesdits circuits d'éclairage avant et arrière (8, 9, 12, 13) lorsque s'est écoulé un intervalle temporel de durée prédéterminée après un arrêt de fonctionnement de la dynamo (21).

15. Bicyclette selon l'une quelconque des revendications précédentes, dans laquelle le système de contrôle (23) comprend une mémoire (24) et est adapté pour :
- recevoir un code d'identification par l'intermédiaire de la première interface de communication (20),
- écrire ledit code d'identification dans la mémoire (24),
- détecter un fonctionnement de la bicyclette (1),
- en cas de fonctionnement de la bicyclette, comparer la valeur du code d'identification à au moins une valeur prédéterminée,
- et en fonction de cette comparaison, déclencher ou non une réaction d'alarme.

16. Bicyclette selon la revendication 15, dans laquelle le système de contrôle est adapté pour déclencher la réaction d'alarme lorsque la valeur du code d'identification correspond à ladite valeur prédéterminée.

17. Bicyclette selon l'une quelconque des revendications précédentes, dans laquelle le système de contrôle (23) comprend une horloge (24) et est adapté pour :
- détecter un fonctionnement de la bicyclette (1),
- après une durée prédéterminée de fonctionnement de la bicyclette, déclencher une réaction d'alarme.

18. Bicyclette selon l'une quelconque des revendications 15 à 17, comprenant au moins un circuit d'éclairage (8, 9, 12, 13) qui comprend au moins un feu,
dans laquelle le système de contrôle (23) est adapté pour commander de manière intermittente le circuit d'éclairage (8, 9, 12, 13) à titre de réaction d'alarme.

19. Bicyclette selon l'une quelconque des revendications 15 à 18, comprenant un haut-parleur (19) commandé par le système de contrôle (23), et dans laquelle le système de contrôle (23) est adapté pour faire émettre un signal sonore à ce haut-parleur (19) à titre de réaction d'alarme.

20. Bicyclette selon l'une quelconque des revendications 15 à 18, dans laquelle le système de contrôle est adapté pour détecter un mouvement de la bicyclette (1) et pour déterminer que la bicyclette est en fonctionnement lorsqu'un mouvement est détecté.

21. Bicyclette selon l'une quelconque des revendications précédentes, verrouillable sur une borne fixe (2), dans laquelle le système de contrôle (23) est adapté pour :
- détecter un verrouillage de la bicyclette (1) à une borne fixe (2),
- faire émettre un signal d'acquit dès lors que le verrouillage de la bicyclette (1) à la borne (2) a été détecté.

22. Bicyclette selon la revendication 21, comprenant au moins un circuit d'éclairage (8, 9, 12, 13) commandé par le système de contrôle, et ledit système de contrôle est adapté pour faire fonctionner ledit circuit d'éclairage par intermittence pendant une durée limitée à titre de signal d'acquit.

23. Système automatique de location de bicyclettes comprenant au moins une bicyclette (1) selon l'une quelconque des revendications précédentes et une infrastructure (2, 2c, 2d) adaptée pour recevoir lesdites informations d'état.

24. Système automatique selon la revendication 23, comportant une pluralité de bicyclettes (1) et dans lequel ladite infrastructure (2, 2c, 2d) comporte :
- une pluralité de postes de stockage (2) adaptés pour recevoir sur chacun au moins une bicyclette (1) aux fins de stockage,
- et une pluralité de deuxièmes interfaces de communication (2a) à courte portée adaptées pour communiquer avec lesdites premières interfaces de communication (20) des bicyclettes, chaque deuxième interface de communication (2a) de l'infrastructure étant associée à au moins un poste de stockage (2) et disposée au voisinage immédiat dudit poste de stockage.

25. Système automatique selon la revendication 24, dans lequel chaque poste de stockage comprend une borne fixe (2).

26. Système automatique selon la revendication 25,
dans lequel la borne fixe (2) comprend une desdites deuxièmes interfaces de communication (2a).

27. Système automatique selon l'une quelconque des revendications 23 à 26, dans lequel ladite deuxième interface de communication (2a) est une interface de communication sans contact comprenant un émetteur/récepteur (2a).

28. Système automatique selon l'une quelconque des revendications 23 à 27, dans lequel l'infrastructure comporte en outre au moins un poste central (2d) centralisant lesdites informations d'état reçues par toutes les deuxièmes interfaces de communication (2a).

## Claims

1. A bicycle fitted with an on-board control system (23) and a first communication interface (20) electrically linked to the control system (23), said bicycle comprising at least one functional element (6a, 6b, 7a, 7b; 10, 11; 14, 15; 21, 22), **characterized in that** said control system is designed to:
- control the state of the functional element (6a, 6b, 7a, 7b; 10, 11; 14, 15; 21, 22), to check whether a maintenance procedure is necessary,
- and communicate to a fixed infrastructure (2, 2c, 2d), via the first communication interface (20), status information concerning the state of said functional element (6a, 6b, 7a, 7b; 10, 11; 14, 15; 21, 22).

2. The bicycle as claimed in claim 1, in which said first communication interface comprises a transceiver (20).

3. The bicycle as claimed in claim 2, in which said first communication interface (20) is a short-range, contactless communication interface.

4. The bicycle as claimed in any one of the preceding claims, in which the control system (23) is designed to:
- detect a fault in the operation of said functional element (6a, 6b, 7a, 7b; 10, 11; 14, 15; 21, 22), and
- generate status information characteristic of said fault and communicate this status information to the first communication interface (20) for transmission to said infrastructure (2, 2c, 2d).

5. The bicycle as claimed in any one of the preceding claims, comprising a main rear lighting circuit (12) comprising a first rear lamp (10), the control system (23) being designed to:
- control said main rear lighting circuit (12), and
- detect a failure in said main rear lighting circuit (12).

6. The bicycle as claimed in claim 5, in which the main rear lighting circuit (12) comprises, in series, a current amplifier (30), a light-emitting diode (10), and a current detector (32).

7. The bicycle as claimed in claim 5 or claim 6, comprising a secondary rear lighting circuit (13) independent of the main rear lighting circuit (12), said secondary rear lighting circuit (13) comprising a second rear lamp (11), and in which the control system (23) is designed to control the secondary rear lighting circuit (13) by making it operate when a failure has been detected in the main rear lighting circuit (12).

8. The bicycle as claimed in any one of claims 5 to 7, comprising at least one brake (14, 15) and a secondary rear lighting circuit (13) independent of the main rear lighting circuit (12), said secondary rear lighting circuit (13) comprising a second rear lamp (11), the control system being designed to:
- detect the actuation of the brake (14, 15), and
- control the secondary rear lighting circuit (13) by making it operate when the actuation of the brake (14, 15) has been detected.

9. The bicycle (1) as claimed in either of claims 7 and 8, in which the secondary rear lighting circuit (13) comprises, in series, a current amplifier (31), a light-emitting diode (11), and a current detector (33).

10. The bicycle as claimed in any one of the preceding claims, comprising at least one brake (14, 15) and a dynamo (21), and in which the control system (23) comprises a memory (24) and is designed to:
- detect an actuation of the brake (14, 15),
- measure an electrical intensity of a current generated by the dynamo (21),
- write to the memory (24) status information characteristic of a failure of the brake (14, 15) when the control system (23) detects the actuation of said brake (14, 15) without detecting a reduction in said electrical intensity,
- transmit said status information characteristic of a failure of the brake to the first communication interface (20).

11. The bicycle as claimed in any one of the preceding claims, comprising two independent front lighting circuits (8, 9), each comprising at least one front lamp (6a, 6b; 7a, 7b), and in which the control system (23) is designed to:
- supply current, at mid-power, to each front lighting circuit (8, 9),
- detect a failure in any one of the front lighting circuits (8, 9), and
- supply one of the front lighting circuits (8, 9) with current, at full power, when a failure has been detected in the other circuit.

12. The bicycle as claimed in claim 11, in which each front lighting circuit (8, 9) comprises, in series, a current amplifier (26, 27), at least one light-emitting diode (6a, 6b; 7a, 7b), and a current detector (28, 29).

13. The bicycle as claimed in any one of the preceding claims, comprising:
- at least one front lighting circuit (8, 9) comprising at least one front lamp (6a, 6b; 7a, 7b),
- at least one rear lighting circuit (12, 13) comprising a first rear lamp (10, 11),
- a dynamo (21),
- a battery (22) electrically linked to the dynamo (21) to be recharged by said dynamo and at least partly supplying the front and rear lighting circuits (8, 9, 12, 13),
in which the control system (23) is designed to:
- control the front and rear lighting circuits (8, 9, 12, 13),
- measure the battery charge (22),
- reduce an electrical intensity supplying the front lighting circuits (8, 9) when the measured charge is less than a predetermined minimum value.

14. The bicycle as claimed in any one of the preceding claims, comprising:
- at least one front lighting circuit (8, 9) comprising at least one front lamp (6a, 6b; 7a, 7b),
- at least one rear lighting circuit (12, 13) comprising a first rear lamp (10, 11),
- a dynamo (21),
- a battery (22) electrically linked to the dynamo (21) to be recharged by said dynamo and at least partly supplying the front and rear lighting circuits (8, 9, 12, 13),
in which the control system (23) comprises a clock (25) and is designed to:
- control the front and rear lighting circuits (8, 9, 12, 13),
- detect the operation of the dynamo (21),
- cut said front and rear lighting circuits (8, 9, 12, 13) when a time interval of predetermined duration has elapsed after the dynamo (21) has stopped operating.

15. The bicycle as claimed in any one of the preceding claims, in which the control system (23) comprises a memory (24) and is designed to:
- receive an identification code via the first communication interface (20),
- write said identification code into the memory (24),
- detect an operation of the bicycle (1),
- if the bicycle is operating, compare the value of the identification code with at least one predetermined value,
- and, depending on this comparison, initiate or not initiate an alarm reaction.

16. The bicycle as claimed in claim 15, in which the control system is designed to initiate the alarm reaction when the value of the identification code corresponds to said predetermined value.

17. The bicycle as claimed in any one of the preceding claims, in which the control system (23) comprises a clock (24) and is designed to:
- detect an operation of the bicycle (1),
- after a predetermined period of operation of the bicycle, initiate an alarm reaction.

18. The bicycle as claimed in any one of claims 15 to 17, comprising at least one lighting circuit (8, 9, 12, 13) which comprises at least one lamp,
in which the control system (23) is designed to intermittently control the lighting circuit (8, 9, 12, 13) as an alarm reaction.

19. The bicycle as claimed in any one of claims 15 to 18, comprising a speaker (19) controlled by the control system (23), and in which the control system (23) is designed to have a sound signal sent to this speaker (19) as an alarm reaction.

20. The bicycle as claimed in any one of claims 15 to 18, in which the control system is designed to detect a movement of the bicycle (1) and to determine that the bicycle is operating when a movement is detected.

21. The bicycle as claimed in any one of the preceding claims, which can be locked on a fixed terminal (2), in which the control system (23) is designed to:
- detect a locking of the bicycle (1) on a fixed terminal (2),
- have an acknowledgement signal sent when the locking of the bicycle (1) on the terminal (2) has been detected.

22. The bicycle as claimed in claim 21, comprising at least one lighting circuit (8, 9, 12, 13) controlled by the control system, and said control system is designed to have said lighting circuit operate intermittently for a limited period as an acknowledgement signal.

23. An automatic bicycle rental system comprising at least one bicycle (1) according to any one of the preceding claims and an infrastructure (2, 2c, 2d) designed to receive said status information.

24. The automatic system as claimed in claim 23, comprising a plurality of bicycles (1) and in which said infrastructure (2, 2c, 2d) comprises:
- a plurality of storage stations (2) designed to receive on each at least one bicycle (1) for storage purposes,
- and a plurality of short-range second communication interfaces (2a) designed to communicate with said first communication interfaces (20) of the bicycles, each second communication interface (2a) of the infrastructure being associated with at least one storage station (2) and disposed in the immediate vicinity of said storage station.

25. The automatic system as claimed in claim 24, in which each storage station comprises a fixed terminal (2).

26. The automatic system as claimed in claim 25, in which the fixed terminal (2) comprises one of said second communication interfaces (2a).

27. The automatic system as claimed in any one of claims 23 to 26, in which said second communication interface (2a) is a contactless communication interface comprising a transceiver (2a).

28. The automatic system as claimed in any one of claims 23 to 27, in which the infrastructure also comprises at least one central station (2d), centralizing said status information received by all the second communication interfaces (2a).

## Patentansprüche

1. Fahrrad, ausgestattet mit einem Bordprüfsystem und einer ersten Kommunikationsschnittstelle, die mit dem Prüfsystem (23) verbunden ist, wobei das Fahrrad zumindest ein Funktionselement (6a, 6b, 7a, 7b; 10, 11; 14, 15; 21, 22) umfasst, **dadurch gekennzeichnet, dass** das genannte Prüfsystem geeignet ist:
- den Zustand des Funktionselements (6a, 6b, 7a, 7b; 10, 11; 14, 15; 21, 22) zu prüfen und zu kontrollieren, ob ein instandsetzungsverfahren erforderlich ist,
- und einer festen Infrastruktur (2, 2c, 2d) über die erste Kommunikationsschnittstelle (20) Zustandsinformationen über den Zustand dieses Funktionselements (6a, 6b, 7a, 7b; 10, 11; 14, 15; 21, 22) mitzuteilen.

2. Fahrrad nach Anspruch 1, wobei die genannte Kommunikationsschnittstelle einen Empfänger/Sender (20) umfasst.

3. Fahrrad nach Anspruch 2, wobei die genannte erste Kommunikationsschnittstelle (20) eine kontaktlose Kommunikationsschnittstelle mit kurzer Reichweite ist.

4. Fahrrad nach einem der vorstehenden Ansprüche, wobei das Prüfsystem (23) geeignet ist:
- einen Funktionsfehler dieses Funktionselements (6a, 6b, 7a, 7b; 10, 11; 14, 15; 21, 22) zu erfassen und
- eine Zustandsinformation zu generieren, die diesen Fehler kennzeichnet, und diese Zustandsinformation der ersten Kommunikationsschnittstelle (20) mitzuteilen, um an die genannte Infrastruktur (2, 2c, 2d) übertragen zu werden.

5. Fahrrad nach einem der vorstehenden Ansprüche, das einen Hauptrückbeleuchtungskreis (12) umfasst, der ein erstes Rücklicht (10) aufweist, wobei das Prüfsystem (23) geeignet ist:
- diesen Hauptrückbeleuchtungskreis (12) zu steuern und
- eine Störung in diesem Hauptrückbeleuchtungskreis (12) zu erfassen.

6. Fahrrad nach Anspruch 5, bei dem der Hauptrückbeleuchtungskreis (12) in Reihe einen Stromverstärker (30), eine Leuchtdiode (10) und eine Stromsonde (32) umfasst.

7. Fahrrad nach Anspruch 5 oder nach Anspruch 6, das einen Sekundärrückbeleuchtungskreis (13) unabhängig vom Hauptrückbeleuchtungskreis (12) aufweist, wobei dieser Sekundärrückbeleuchtungskreis (13) ein zweites Rücklicht (11) umfasst und bei dem das Prüfsystem (23) geeignet ist, den Sekundärrückbeleuchtungskreis (13) zu steuern, indem er ihn im Fall der Erfassung einer Störung im Hauptrückbeleuchtungskreis (12) in Betrieb nimmt.

8. Fahrrad nach einem der Ansprüche 5 bis 7, das zumindest eine Bremse (14, 15) und einen Sekundärrückbeleuchtungskreis (13) unabhängig vom Hauptrückbeleuchtungskreis (12) aufweist, wobei der genannte Sekundärrückbeleuchtungskreis (13) ein zweites Rücklicht (11) umfasst und das Prüfsystem geeignet ist:
- die Betätigung der Bremse (14, 15) zu erfassen und
- den Sekundärbeleuchtungskreis (13) zu steuern, indem er anlässlich der Erfassung der Betätigung der Bremse (14, 15) in Betrieb genommen wird.

9. Fahrrad (1) nach einem der Ansprüche 7 und 8, bei dem der Sekundärrückbeleuchtungskreis (13) in Reihe einen Stromverstärker (31), eine Leuchtdiode (11) und eine Stromsonde (33) aufweist.

10. Fahrrad nach einem der vorstehenden Ansprüche, das zumindest eine Bremse (14, 15) und ein Dynamo (21) aufweist und bei dem das Prüfsystem (23) einen Speicher (24) umfasst und geeignet ist:
- eine Betätigung der Bremse (14, 15) zu erfassen,
- eine Stromstärke eines mit dem Dynamo (21) erzeugten Stroms zu messen,
- in den Speicher (24) eine Zustandsinformation, die für eine Störung der Bremse (14, 15) kennzeichnend ist, einzutragen, wenn das Prüfsystem (23) die Betätigung der genannten Bremse (14, 15) erfasst, ohne eine Verringerung dieser Stromstärke zu erfassen,
- die Zustandsinformation, die für einen Ausfall der Bremse kennzeichnend ist, an die erste Kommunikationsschnittstelle (20) zu übertragen.

11. Fahrrad nach einem der vorstehenden Ansprüche, das zwei unabhängige Vorderbeleuchtungskreise (8, 9) aufweist, die jeweils zumindest ein Vorderlicht (6a, 6b; 7a, 7b) umfassen und bei dem das Prüfsystem (23) geeignet ist:
- die Stromversorgung jedes Vorderbeleuchtungskreises (8, 9) bei halber Leistung zu gewährleisten.
- eine Störung in einem der Vorderbeleuchtungskreise (8, 9) zu erfassen und
- einen der Vorderbeleuchtungskreise (8, 9) mit Strom bei voller Leistung zu versorgen, wenn eine Störung in einem anderen Kreis erfasst wurde.

12. Fahrrad nach Anspruch 11, bei dem jeder Vorderbeleuchtungskreis (8, 9) in Reihe einen Stromverstärker (26, 27), eine Leuchtdiode (6a, 6b, 7a, 7b) und eine Stromsonde (28, 29) aufweist.

13. Fahrrad nach einem der vorstehenden Ansprüche, bestehend aus:
- zumindest einem Vorderbeleuchtungskreis (8, 9), der zumindest ein Vorderlicht (6a, 6b, 7a, 7b) umfasst,
- zumindest einem Rückbeleuchtungskreis (12, 13), der ein erstes Rücklicht (10, 11) umfasst,
- einem Dynamo (21),
- einer Batterie (22), die elektrisch mit dem Dynamo (21) verbunden ist, um von dem genannten Dynamo erneut geladen zu werden, wobei zumindest teilweise die Vorder- und Rückbeleuchtungskreise (8, 9, 12, 13) versorgt werden,
- Steuerung der Vorder- und Rückbeleuchtungskreise (8, 9, 12, 13),
- Messung des Ladezustands der Batterie (22),
- Verringerung der Stromstärke zur Versorgung der Vorderbeleuchtungskreise (8, 9), sofern die gemessene Ladung geringer als ein vorbestimmter Mindestwert ist.

14. Fahrrad nach einem der vorstehenden Ansprüche, bestehend aus:
- zumindest einem Vorderbeleuchtungskreis (8, 9), der zumindest ein Vorderlicht (6a, 6b, 7a, 7b) umfasst,
- zumindest einem Rückbeleuchtungskreis (12, 13), der zumindest ein erstes Rücklicht (10, 11) umfasst,
- einem Dynamo (21)
- einer Batterie (22), die elektrisch mit dem Dynamo (21) verbunden wird, um von dem genannten Dynamo erneut geladen zu werden, wobei die Vorder- und Rückbeleuchtungskreise (8, 9, 12, 13) zumindest teilweise versorgt werden,
bei dem das Prüfsystem (23) eine Uhr (25) umfasst und geeignet ist:
- die Vorder- und Rückbeleuchtungskreise (8, 9, 12, 13) zu versorgen,
- den Betrieb des Dynamos (21) zu erfassen,
- die genannten Vorder- und Rückbeleuchtungskreise (8, 9, 12, 13) zu trennen, wenn ein vorbestimmter Zeitabschnitt nach einer Stilllegung des Dynamos (21) vergangen ist.

15. Fahrrad nach einem der vorstehenden Ansprüche, bei dem das Prüfsystem (23) einen Speicher (24) umfasst und geeignet ist:
- einen Identifikations-Code über die erste Kommunikationsschnittstelle zu empfangen,
- diesen Identifikations-Code in den Speicher (24) einzutragen,
- einen Betrieb des Fahrrads (1) zu erfassen,
- im Fall des Fahrradbetriebs den Wert des Identifikations-Code mit zumindest einem vorbestimmten Wert zu vergleichen,
- und in Abhängigkeit von diesem Vergleich eine Alarmreaktion auszulösen oder nicht.

16. Fahrrad nach Anspruch 15, bei dem das Prüfsystem geeignet ist, die Alarmreaktion auszulösen, wenn der Wert des Identifikations-Codes dem genannten vorbestimmten Wert entspricht.

17. Fahrrad nach einem der vorstehenden Ansprüche, bei dem das Prüfsystem (23) eine Uhr (24) umfasst und geeignet ist:
- einen Betrieb des Fahrrads (1) zu erfassen,
- nach einer vorbestimmten Betriebsdauer des Fahrrads eine Alarmfunktion auszulösen.

18. Fahrrad nach einem der Ansprüche 15 bis 17, bestehen aus zumindest einem Beleuchtungskreis (8, 9, 12, 13), der zumindest ein Licht umfasst,
bei dem das Prüfsystem (23) geeignet ist, den Beleuchtungskreis (8, 9, 12, 13) im Rahmen der Alarmreaktion intermittierend zu steuern.

19. Fahrrad nach einem der Ansprüche 15 bis 18, bestehend aus einem Lautsprecher (19, der mit dem Prüfsystem (23) gesteuert wird, und bei dem das Prüfsystem (23) geeignet ist, ein Tonsignal an diesen Lautsprecher (19) im Rahmen der Alarmreaktion zu senden.

20. Fahrrad nach einem der Ansprüche 15 bis 18, bei dem das Prüfsystem geeignet ist, eine Bewegung des Fahrrads (1) zu erfassen und zu bestimmen, ob das Fahrrad bei der Erfassung einer Bewegung in Betrieb ist.

21. Fahrrad nach einem der vorstehenden Ansprüche, das an einer Festsäule ((2) verriegelbar ist und bei dem das Prüfsystem (23) geeignet ist:
- die Verriegelung des Fahrrads (1) an einer Festsäule (2) zu erfassen,
- ein Bestätigungssignal zu senden, sobald die Verriegelung des Fahrrads (1) an der Festsäule (2) erfasst wurde.

22. Fahrrad nach Anspruch 21, das zumindest einem Beleuchtungskreis (8, 9, 12, 13) umfasst, der durch das Prüfsystem gesteuert wird, wobei das genannte Prüfsystem geeignet ist, den genannten Beleuchtungskreis intermittierend während einer beschränkten Dauer im Rahmen des Bestätigungssignals in Betrieb zu nehmen.

23. Automatisches Vermietungssystem von Fahrrädern nach einem der vorstehenden Ansprüche, das zumindest ein Fahrrad (1) und eine Infrastruktur (2, 2c, 2d) umfasst, die geeignet ist, die genannten Zustandsinformationen zu empfangen.

24. Automatisches System nach Anspruch 23, das eine Vielzahl von Fahrrädern (1) umfasst und bei dem die genannte Infrastruktur (2, 2c, 2d) folgendes aufweist:
- eine Vielzahl von Lagerposten (2), die geeignet sind jeweils ein Fahrrad (1) zum Zwecke der Lagerung aufzunehmen,
- und eine Vielzahl von zweiten Kommunikationsschnittestellen (2a) mit kurzer Reichweite, die geeignet sind, mit diesen ersten Kommunikationsschnittstellen (20) der Fahrräder zu kommunizieren, wobei jede zweite Kommunikationsschnittstelle (2a) der Infrastruktur mit zumindest einem Lagerposten (2) verbunden und in der unmittelbaren Nachbarschaft des genannten Lagerpostens angeordnet ist.

25. Automatisches System nach Anspruch 24, bei dem jeder Lagerposten eine Festsäule (2) umfasst.

26. Automatisches System nach Anspruch 25, bei dem die Festsäule (2) eine der genannten zweiten Kommunikationsschnittstellen (2a) umfasst.

27. Automatisches System nach einem der Ansprüche 23 bis 26, bei dem diese Kommunikationsschnittstelle (2a) eine kontaktlose Kommunikationsschnittstelle ist, die einen Sender/Empfänger (2a) umfasst.

28. Automatisches System nach einem der Ansprüche 23 bis 27, bei dem die Infrastruktur darüber hinaus zumindest einen zentralen Posten (2d) aufweist, der die genannten Zustandsinformationen zentralisiert, die von den beiden Kommunikationsschnittstellen (2a) empfangen werden.
